# EUROPÄISCHE PATENTSCHRIFT

(11) **EP 1 753 011 B1**
(45) Veröffentlichungstag und Bekanntmachung des Hinweises auf die Patenterteilung: **03.10.2012**
(21) Anmeldenummer: 05017683.3
(22) Anmeldetag: 13.08.2005
(51) Int. Cl.: H01J 37/32

(54) **Verfahren zur Erzeugung von Ansteuersignalen für HF-Leistungsgeneratoren**
Method for providing control signals for high frequency power generators
Méthode de fournir les signaux de commande pour les générateurs de puissance à haute-fréquence

(43) Veröffentlichungstag der Anmeldung: 14.02.2007
(73) Patentinhaber: HÜTTINGER Elektronik GmbH + Co. KG, 79111 Freiburg (DE)
(72) Erfinder: Blattner, Manfred, 79312 Emmendingen (DE); Winterhalter, Markus, 79189 Bad Krozingen (DE); Mann, Ekkehard, 79194 Gundelfingen (DE)
(74) Vertreter: Schiz, Jochen

(56) Entgegenhaltungen:
- US-A- 5 087 857
- US-A- 5 824 606
- US-A1- 2003 215 373

## Beschreibung

Die Erfindung betrifft ein Verfahren zur Erzeugung von Ansteuersignalen von zumindest zwei HF-Leistungsgeneratoren, die einen Plasmaprozess mit HF-Leistung versorgen, bei dem in einer HF-Generatoransteuereinrichtung zumindest zwei jeweils einen HF-Leistungsgenerator ansteuernde Ansteuersignale erzeugt werden, sowie eine HF-Generatoransteuereinrichtung.

HF-Plasmaprozesse werden beispielsweise zum Ätzen, Beschichten und Veraschen verwendet. Bislang wurden in solchen Prozessen relativ kleine Flächen bearbeitet. In Plasmaprozessen sollen jedoch immer größere Flächen, beispielsweise größere Wafer in der Halbleiterindustrie oder größere Flatpaneldisplays, bearbeitet werden. Während es bisher relativ einfach möglich war, ein homogenes Plasma über der zu bearbeitenden Fläche zu erzeugen, so gelangen die Dimensionen der nunmehr zu beschichtenden oder zu ätzenden Flächen in den Bereich der Wellenlänge der Anregungssignale des Plasmas oder der Harmonischen der Anregungssignale. Dadurch kommt es zu Wellenstrukturen im Plasma und sind homogene Plasmabearbeitungen nur sehr schwer möglich.

Um dem entgegenzuwirken ist es bekannt, mehrere HF-Plasmageneratoren zu verwenden, die bei unterschiedlichen oder gleichen Frequenzen betrieben werden. Aus der US 5,698,062 ist beispielsweise eine HF-Generatoransteuereinrichtung bekannt geworden, die eine Niederspannungsquelle und einen Frequenzteiler aufweist. Über den Frequenzteiler werden zwei HF-Verstärker, die auch als HF-Generatoren betrachtet werden können, angesteuert. Diese Speisen an unterschiedlichen Stellen HF-Leistung in den Plasmaprozess ein.

Aus der US 5,824,606 ist es bekannt, zwei HF-Generatoren mit derselben Frequenz anzusteuern und über diese HF-Generatoren an unterschiedlichen Stellen im Plasmaprozess HF-Leistung einzuspeisen. Über einen Phasenschieber wird die Phasenlage der von den HF-Generatoren abgegebenen Signale zueinander eingestellt.

In der FPD Herstellung laufen Versuche, Plasma mit MF (10kHz bis 1MHz) anzuregen. Dazu werden mehrere Elektrodenpaare in unmittelbarer Nähe zu weiteren Elektrodenpaaren angeordnet. Jedes Elektrodenpaar wird von einem MF-Generator versorgt. Die MF-Generatoren laufen nicht synchron und nicht zwingend mit der gleichen Frequenz. Deswegen kann es zu hohen Spannungen und Schwebungen zwischen zwei benachbarten Elektrodenpaaren kommen. Diese hohen Spannungen können zu Arcs zwischen den benachbarten Elektrodenpaaren führen, die höchst unerwünscht sind. Es wäre vorteilhaft, wenn die Generatoren synchronisiert werden könnten und die Phase der einzelnen Generatoren eingestellt werden könnten.

Aus der US 2003/0215373 A1 ist ein HF-Generator bekannt, der durch eine Systemsteuerung angesteuert wird. In dem HF-Generator ist eine Steuerkarte vorgesehen, die ein HF-Signal mittels eines "direct digital synthesis circuit" erzeugt. Dieses HF-Signal wird einem Treiber und anschließend einer Verstärkerstufe zugeführt. Der HF-Generator weist weiterhin einen Koppler auf, der Leistungssignale auskoppelt und diese der Steuerkarte zuführt, die in Anhängigkeit von den Leistungssignalen u. a. die Frequenz der HF Quelle einstellt.

Die US 5,087,857 offenbart eine Anordnung zur Speisung eines Plasmas. Dabei wird in einem "voltage combiner" eine Referenzspannung mit einem Signal eines Funktionsgenerators moduliert und einer Stromversorgung zugeführt.

Aufgabe der vorliegenden Erfindung ist es, ein Verfahren zur Ansteuerung von HF-Leistungsgeneratoren zu schaffen, mit dem eine flexiblere Einstellung und Beeinflussung der Leistungsabgabe der HF-Leistungsgeneratoren beziehungsweise des Plasmaprozesses möglich ist, sowie eine entsprechende HF-Generatoransteuereinrichtung bereitzustellen.

Diese Aufgabe wird erfindungsgemäß durch ein Verfahren der eingangs genannten Art gelöst, bei dem die Ansteuersignale unter Verwendung je eines Funktionsgenerators, insbesondere digitalen Funktionsgenerators, insbesondere Sinusgenerators, erzeugt werden. Durch die Verwendung je eines digitalen Funktionsgenerators, die jeder für sich unabhängig einstellbar sind, bei der Erzeugung der Ansteuersignale ist es möglich, nahezu beliebige Ansteuersignale zu erzeugen. Insbesondere lassen sich die Frequenz und die Phasenlage jedes einzelnen Ansteuersignals sowie unterschiedliche Beziehungen der unterschiedlichen Ansteuersignale zueinander einstellen. Dies führt dazu, dass die HF-Leistungseinspeisung in den Plasmaprozess gezielt eingestellt und variiert werden kann. Somit ist es möglich, eine geeignete Kombination von Ansteuersignalen für unterschiedliche HF-Leistungsgeneratoren zu erzeugen, so dass es wiederum möglich ist, das Plasma auch bei einer großflächigen Beschichtung oder bei großflächigen Ätzprozessen zu homogenisieren. Im Sinne dieser Erfindung wird unter Hochfrequenz eine Frequenz im Bereich 10kHz - 300MHz verstanden.

Wenn die Leistungsverteilung in der Plasmakammer erfasst beziehungsweise gemessen wird, können die dabei gewonnenen Größen verwendet werden, um die Ansteuersignale zur Erzeugung eines homogenen Plasmas geeignet zu wählen. Insbesondere kann die Leistungsverteilung in der Plasmakammer durch entsprechende Beeinflussung der Ansteuersignale eingestellt und geregelt werden. Durch die Verwendung eines digitalen Funktionsgenerators hat ein Anwender sehr viel größere Einstellmöglichkeiten als dies bei einer analogen Erzeugung der Ansteuersignale möglich wäre.

Bei einer bevorzugten Verfahrensvariante wird eine Phasen- und/oder Frequenzbeziehung der Ansteuersignale zueinander eingestellt. Hierbei sind verschiedene Szenarien, je nach Anwendungsbereich, denkbar. Beispielsweise können die Ansteuersignale mit derselben Frequenz erzeugt werden, jedoch jeweils einen Phasenversatz zueinander aufweisen. Weiterhin ist es denkbar, dass zumindest zwei Ansteuersignale unterschiedliche Frequenzen aufweisen. Dabei können die Frequenzen beliebig gewählt werden oder in einer bestimmten mathematischen Beziehung zueinander stehen. Beispielsweise können die Frequenzen als Vielfache einer Grundfrequenz gewählt werden.

Die Einstellung der Ansteuersignale kann vorzugsweise über mindestens eine digitale Schnittstelle der HF-Generatoransteuereinrichtung erfolgen. Dabei kann vorgesehen sein, dass mehrere Funktionsgeneratoren durch eine einzige Schnittstelle beeinflussbar sind. Es versteht sich, dass auch für jeden Funktionsgenerator eine Schnittstelle vorgesehen sein kann.

Vorteilhafterweise erfolgt die Einstellung der Ansteuersignale über einen programmierbaren Logikbaustein, insbesondere einen FPGA oder Prozessor.

Je nach Verhalten des Plasmaprozesses kann es notwendig sein, die Phasenlage zwischen den Ansteuersignalen zu verändern. Dies kann beispielsweise dadurch geschehen, dass die Phasenlage eines oder mehrerer Ansteuersignale verändert wird. Dabei ist es bevorzugt, wenn eine Änderung der Phasenlage eines Ansteuersignals über eine Zeitspanne im Bereich 1µs - 10s, vorzugsweise 1ms - 2s, besonders bevorzugt 100ms - 1s, erfolgt. Dies bedeutet, dass die Änderung der Phasenlage eines Ansteuersignals von einer ersten zu einer zweiten Phasenlage fließend, beziehungsweise kontinuierlich, man könnte auch sagen graduell oder mit einer Rampe erfolgt. Dadurch wird sichergestellt, dass keine abrupte Phasenänderung, also kein Phasensprung, auftritt, der den HF-Generator beschädigen oder den Plasmaprozess stören könnte.

Um sicherzustellen, dass eine Phasenänderung unabhängig von der Anfangs- und Endphasenlage immer mit derselben Rampe erfolgt, kann bei einer bevorzugten Verfahrensvariante vorgesehen sein, dass die Geschwindigkeit der Phasenlagenänderung, insbesondere in %/s oder in Grad/s, eingestellt oder vorgegeben wird.

Die Verwendung eines digitalen Funktionsgenerators liefert auch die Möglichkeit einer weiteren Verfahrensvariante, bei der zumindest ein Ansteuersignal frequenz- oder phasenmoduliert wird. Die Frequenz - oder Phasenmodulation kann dabei über ein externes Signal, das einer HF-Generatoransteuereinrichtung gespeist wird, oder über eine entsprechende Programmierung, also insbesondere eine Software, erfolgen, so dass der oder die digitalen Funktionsgeneratoren entsprechend angesteuert werden, um ein frequenz - oder phasenmoduliertes Ansteuersignal auszugeben. Die Phasen - oder Frequenzmodulation kann zur Prozessoptimierung verwendet werden.

Eine Verfahrensvariante zeichnet sich dadurch aus, dass bei einem vorgebbaren Ereignis, insbesondere einer Arcerkennung im Plasmaprozess, die Phasenbeziehung von zumindest zwei Ansteuersignalen, insbesondere sprungartig, geändert wird. Durch diese Maßnahme ändert sich die Leistungszufuhr zum Plasmaprozess schlagartig, so dass ein Arc nicht weiter mit HF-Leistung versorgt wird und zum Erlöschen kommt. Es versteht sich, dass sich durch eine Änderung der Phasenlage nur eines Ansteuersignals auch die Phasenbeziehung zweier Ansteuersignale ändert. Um die Phasenbeziehung zumindest zweier Ansteuersignale zu ändern, kann es daher ausreichend sein, die Phasenlage nur eines Ansteuersignals zu verändern.

Alternativ oder zusätzlich kann vorgesehen sein, dass bei einem vorgebbaren Ereignis, insbesondere einer Arcerkennung im Plasmaprozess, zumindest ein Ansteuersignal, vorzugsweise alle Ansteuersignale, vorübergehend unterbrochen werden. Auch dies kann zum Erlöschen eines Arcs führen. Dabei ist es vorteilhaft, wenn diese Arc - Austastung mit den HF-Generatoren synchronisiert wird.

Wenn die Frequenzen der Ansteuersignale als ganzzahlige Vielfache einer festen Frequenz im Bereich 1 - 6 MHz, insbesondere als ganzzahlige Vielfache von 3,39 MHz gewählt werden, kann das Verfahren besonders vorteilhaft bei Ätzprozessen eingesetzt werden. Durch eine Multiplikation der Frequenz von 3,39 MHz mit dem Faktor 4 gelangt man zu der besonders bevorzugten ISM (Industrial, Scientific, and Medical)-Frequenz von 13,56 MHz und durch eine Multiplikation mit dem Faktor 8 zu der ISM-Frequenz von 27,12 MHz. Durch das erfindungsgemäße Verfahren ist es dabei insbesondere möglich, ein Ansteuersignal bei einer ISM-Frequenz und ein anderes Ansteuersignal bei einem anderen Vielfachen der Frequenz 3,39 MHz zu erzeugen. Vorteilhafterweise ist die Taktfrequenz ein ganzzahliges Vielfaches der besonders bevorzugten ISM-Frequenz 13,56 MHz, so können die besonders bevorzugten ISM-Frequenzen besonders einfach eingestellt werden.

Vorteilhafterweise werden die digitalen Frequenzgeneratoren durch eine gemeinsame Taktfrequenz angesteuert. Durch diese Maßnahme lässt sich die Frequenz und Phasenbeziehung zweier Ansteuersignale zueinander besonders einfach einstellen. Weiterhin ist es denkbar, dass auch ein Prozessor, der die Funktionsgeneratoren ansteuert ebenfalls mit der gemeinsamen Taktfrequenz versorgt wird, so dass sichergestellt ist, dass Daten von dem Prozessor in den Funktionsgeneratoren synchron übernommen werden.

In den Rahmen der Erfindung fällt außerdem eine HF-Generatoransteuereinrichtung zur Ansteuerung von zumindest zwei einen Plasmaprozess mit HF-Leistung speisenden HF-Generatoren, wobei die Ansteuereinrichtung zumindest zwei Ansteuersignale generiert, und die Ansteuereinrichtung für jedes Ansteuersignal eine einen insbesondere digitalen Funktionsgenerator, insbesondere Sinusgenerator, aufweisende Signalerzeugungsanordnung umfasst. Mit einer derartigen Anordnung wird eine vielfältige Erzeugung von Ansteuersignalen möglich. Insbesondere können Phasenlage und Frequenz jedes einzelnen Ansteuersignals frei eingestellt werden. Somit ergeben sich viele Möglichkeiten, die HF-Leistungsgeneratoren und damit den Plasmaprozess zu beeinflussen. Besonders bevorzugt ist der AD9959 von Analog Devices, in dem gleich vier digitale Funktionsgeneratoren integriert sind.

Besonders bevorzugt ist es, wenn der Funktionsgenerator als DDS (Direct Digital Synthesizer) ausgebildet ist. Mit einem DDS kann insbesondere ein stufenförmiges Sinussignal erzeugt werden. Die Phasenlage kann dabei im Wesentlichen frei eingestellt werden. Die Frequenz kann je nach Leistungsfähigkeit des DDS in einem weiten Bereich ebenfalls eingestellt werden. Für HF-Plasmaanwendungen besonders geeignet ist ein AD9952 der Firma Analog Devices.

Besonders vorteilhaft ist es, wenn die Signalerzeugungsanordnungen eine dem digitalen Funktionsgenerator nachgeschaltete Filtereinrichtung aufweisen. Das Ausgangssignal des digitalen Funktionsgenerators kann stufenförmig sein, insbesondere eine stufenförmige Sinusform aufweisen. Wird dieses Signal an eine Filtereinrichtung gegeben, so kann die Kurve dadurch geglättet werden, so dass ein analoges Sinussignal entsteht. Mit einem solchen Sinussignal können bestimmte HF-Generatoren angesteuert werden.

Um ein Ansteuersignal für neuere HF-Generatoren zu erzeugen, ist es vorteilhaft, wenn die Signalerzeugungsanordnungen einen das jeweilige Ansteuersignal erzeugenden Komparator aufweisen. Durch einen Komparator kann beispielsweise aus einem geglätteten Sinussignal ein Rechtecksignal gewonnen werden, mit dem der HF-Generator angesteuert werden kann. Dabei kann vorgesehen sein, dass der Funktionsgenerator selbst einen Komparator aufweist, so dass das digitalisierte Sinussignal zunächst auf eine Filtereinrichtung gegeben wird, wo es geglättet wird, und das dort erhaltene Signal wieder an den Funktionsgenerator übergeben wird, wo es dem Komparator des Funktionsgenerators zugeführt wird.

Besonders bevorzugt ist es, wenn ein Prozessor zur Ansteuerung der Signalerzeugungsanordnungen vorgesehen ist. Dadurch besteht die Möglichkeit, die Funktionsgeneratoren der Signalgeneratoranordnungen gezielt zu programmieren. Der Prozessor kann über eine oder mehrere Schnittstellen steuerbar und/oder programmierbar sein.

Eine Synchronisation wird möglich, wenn ein Oszillator zur Erzeugung eines Taktsignals vorgesehen ist, der mit den Signalerzeugungsanordnungen und/oder dem Prozessor verbunden ist.

Bei einer besonders bevorzugten Ausgestaltung der Erfindung kann zumindest eine Schnittstelle, insbesondere eine digitale Schnittstelle und/oder Benutzerschnittstelle (Bedienpanel), vorgesehen sein. Dadurch ist es möglich, insbesondere über den Prozessor, auf die Funktionsgeneratoren zuzugreifen. So kann beispielsweise die Frequenz oder die Phase in einem vorgegebenen Bereich durch einen Benutzer geändert werden. Mithilfe solcher Schnittstellen ist es außerdem möglich, eine automatische Regelung der Ansteuersignale, insbesondere der Frequenzen und Phasenlagen der Ansteuersignale, durchzuführen. Es kann vorgesehen sein, dass mindestens zwei Signalgeneratoranordnungen von einer Schnittstelle steuerbar sind.
Dabei sind jeweils beide Signalgeneratoranordnungen steuerbar und können sowohl in Frequenz als auch in Phase jeweils unabhängig oder abhängig voneinander eingestellt werden.

Die HF-Generatoransteuereinrichtung kann weiterhin oder alternativ zu dem Prozessor einen programmierbaren digitalen Logikbaustein, insbesondere einen FPGA, aufweisen, der an die Schnittstelle(n) und an die Signalgeneratoranordnungen angeschlossen ist, wobei der digitale Logikbaustein als Prozessor ausgebildet sein kann.

Die Erfindung umfasst außerdem eine HF-Plasmaanregungsanordnung, mit wenigstens zwei HF-Generatoren, die durch eine oben beschriebene HF-Generatoransteuereinrichtung angesteuert sind. Dabei können HF-Plasmaanregungsanordnungen solche sein, wie sie beispielsweise in der FPD-Herstellung bei Frequenzen von 3,39 MHz und deren Vielfachen eingesetzt werden. Außerdem können solche HF-Plasmaanregungsanordnungen auch Beschichtungsanlagen im Bereich von 10kHz bis 1MHz sein, in denen mehrere Elektrodenpaare in unmittelbarer Nähe angeordnet sind und in denen die Ausgangssignale benachbarter Generatoren synchronisiert werden und deren Phasenlage gegeneinander eingestellt wird.

Weitere Merkmale und Vorteile der Erfindung ergeben sich aus der nachfolgenden Beschreibung von Ausführungsbeispielen der Erfindung, anhand den Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

Bevorzugte Ausführungsbeispiele der Erfindung sind in der Zeichnung schematisch dargestellt und werden nachfolgend mit Bezug zu den Figuren der Zeichnung näher erläutert. Es zeigt:
- **Fig. 1**: eine schematische Darstellung einer HF-Plasmaanregungsanordnung;
- **Fig. 2**: eine HF-Generatoransteuereinrichtung;
- **Fig. 3**: eine Darstellung von Signalverläufen an den Stellen A, B, C der Fig. 2;
- **Fig. 4a** - **Fig. 4c**: beispielhaft mehrere mögliche Kombinationen von Ansteuersignalen.

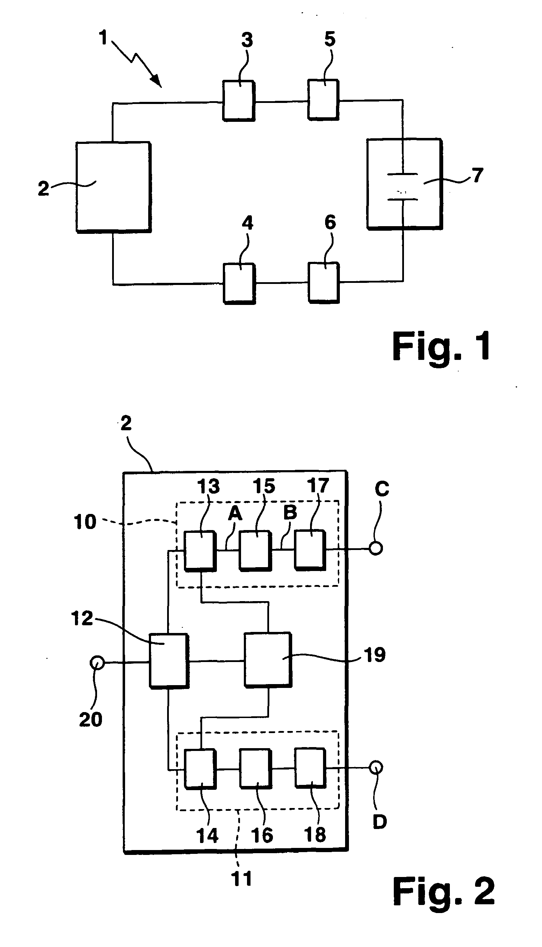

Die Fig. 1 zeigt eine HF-Plasmaanregungsanordnung 1, die eine noch näher zu beschreibende HF-Generatoransteuereinrichtung 2 aufweist, die im Ausführungsbeispiel zwei Ansteuersignale für einen ersten und einen zweiten HF-Leistungsgenerator 3, 4 generiert. Die HF-Leistungsgeneratoren 3, 4 stehen jeweils über ein Anpassungsnetzwerk 5, 6 mit einer Plasmakammer 7 in Verbindung, in der durch Einspeisen von HF-Leistung über die zwei HF-Leistungsgeneratoren 3, 4 ein Plasmaprozess durchgeführt wird.

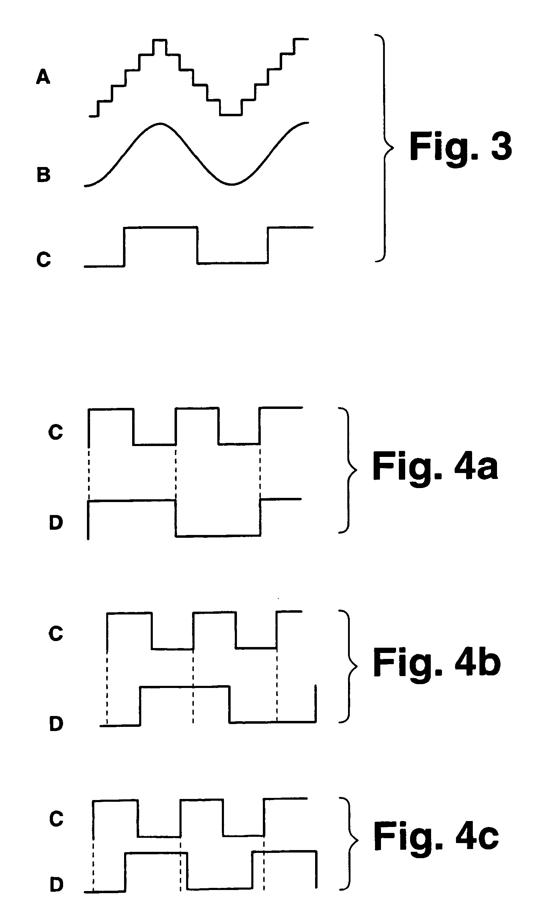

In der Fig. 2 ist die HF-Generatoransteuereinrichtung 2 dargestellt. Diese umfasst zwei Signalgeneratoranordnungen 10, 11 zur Erzeugung der Ansteuersignale. Über einen Prozessor 12 wird den Signalgeneratoranordnungen 10, 11 vorgegeben, welche Art von Ausgangssignal erzeugt werden soll. Insbesondere werden die Frequenz und Phase des Ansteuersignals vorgegeben. Aufgrund dieser Vorgabe wird in digitalen Funktionsgeneratoren 13, 14 ein Signal erzeugt, wie dies beispielsweise durch das Signal A (Fig. 3, das Signal A entspricht dem Signal an der Stelle A der Fig. 2) dargestellt ist. Da das Signal A digital erzeugt wird, ist es stufenförmig. Dieses Signal wird einer Filtereinrichtung 15 beziehungsweise 16 zugeführt, wo eine Glättung erfolgt, so dass beispielsweise ein sinusförmiges Signal B erzeugt wird. Dieses kann nun wiederum einem Komparator 17, 18 zugeführt werden, der daraus eine Rechtecksignal gemäß Signal C erzeugt.

Die HF-Generatoransteuereinrichtung 2 umfasst weiterhin einen Oszillator 19, der einen gemeinsamen Takt vorgibt. Insbesondere liefert der Oszillator 19 seinen Takt an die digitalen Funktionsgeneratoren 13, 14, die im Ausführungsbeispiel als so genannte DDS ausgeführt sind, und an den Prozessor 12. Um die Erzeugung der Ansteuersignale beeinflussen zu können, können Schnittstellen 20 vorgesehen sein, von denen in der Fig. 2 nur eine dargestellt ist. Beispielsweise kann einem Benutzer dadurch die Möglichkeit gegeben werden, die Phasenlage und/oder die Frequenz der Ansteuersignale einzustellen beziehungsweise zu verstellen. Im Prozessor 12 kann dabei beispielsweise ein über die Schnittstelle 20 eingegebenes Signal im Bereich zwischen 0 - 5 V auf eine Phase im Bereich zwischen 0 - 360° abgebildet werden. Es ist jedoch auch denkbar, dass ein vorgegebener Spannungsbereich auf eine Frequenz im Bereich 10kHz - 300 MHz oder auf einen Bereich von Multiplikatoren, mit denen eine Grundfrequenz von zum Beispiel 3,39 MHz multipliziert wird, abgebildet wird. Alternativ kann ein vorgegebener Spannungsbereich auf ganzzahlige Teiler abgebildet werden, mit denen eine vorgegebene Grundfrequenz von beispielsweise 27,12 MHZ dividiert wird.

In den Figuren 4a - 4c sind unterschiedliche Verläufe für Ansteuersignale C, D gezeigt. In der Fig. 4a sind die Signale C, D miteinander synchronisiert, wobei das Ansteuersignal C im Vergleich zum Ansteuersignal D die doppelte Frequenz aufweist.

In der Fig. 4b haben die Signale C, D dieselbe Frequenzbeziehung, d. h. Signal C hat die doppelte Frequenz des Signals D, jedoch ist das Signal D gegenüber den Signal C phasenverschoben.

In der Fig. 4c haben die Signale C, D unterschiedliche Frequenzen und keine bestimmte Phasenbeziehung. Insbesondere hat das Signal D eine Frequenz, die von der des Signals C abweicht. Keines der Signale C, D ist ein ganzzahliges Vielfaches des jeweils anderen Signals C, D.

Die Erfindung wurde anhand von zwei HF-Leistungsgeneratoren und zwei Ansteuersignalen C, D erläutert. Er versteht sich, dass HF-Generatoransteuereinrichtungen 2 mit mehr als zwei Signalerzeugungsanordnungen 10, 11 ausgestattet werden können, um entsprechend mehr Ansteuersignale C, D zu erzeugen, die bezüglich Frequenz und Phase in unterschiedlichen Beziehungen zueinander stehen können.

## Patentansprüche

1. Verfahren zur Erzeugung von Ansteuersignalen (C, D) von zumindest zwei HF-Leistungsgeneratoren (3, 4), die einen Plasmaprozess mit HF-Leistung versorgen, bei dem in einer HF-Generatoransteuereinrichtung (2) zumindest zwei jeweils einen HF-Leistungsgenerator (3, 4) ansteuernde Ansteuersignale (C, D) erzeugt werden, **dadurch gekennzeichnet, dass** die Ansteuersignale (C, D) unter Verwendung je eines Funktionsgenerators (13,14), insbesondere digitalen Funktionsgenerators, bevorzugt digitalen Sinusgenerators, erzeugt werden, wobei zumindest zwei Ansteuersignale (C, D) unterschiedliche Frequenzen aufweisen.

2. Verfahren nach Anspruch 1, **dadurch gekennzeichnet, dass** eine Phasen- und/oder Frequenzbeziehung der Ansteuersignale (C, D) zueinander eingestellt wird.

3. Verfahren nach einem der vorhergehenden Ansprüche, **dadurch gekennzeichnet, dass** die Einstellung der Ansteuersignale (C, D) über mindestens eine digitale Schnittstelle der HF-Generatoransteuereinrichtung (2) erfolgt.

4. Verfahren nach einem der vorhergehenden Ansprüche, **dadurch gekennzeichnet, dass** die Einstellung der Ansteuersignale (C, D) über einen programmierbaren Logikbaustein, insbesondere einen FPGA oder Prozessor, erfolgt.

5. Verfahren nach einem der vorhergehenden Ansprüche, **dadurch gekennzeichnet, dass** eine Änderung der Phasenlage eines Ansteuersignals (C, D) über eine Zeitspanne im Bereich 1µs - 10s, vorzugsweise 1ms - 2s, besonders bevorzugt 100ms - 1s, erfolgt.

6. Verfahren nach einem der vorhergehenden Ansprüche, **dadurch gekennzeichnet, dass** die Geschwindigkeit der Phasenlagenänderung, insbesondere in %/s, eingestellt wird.

7. Verfahren nach einem der vorhergehenden Ansprüche, **dadurch gekennzeichnet, dass** zumindest ein Ansteuersignal (C, D) frequenz - oder phasenmoduliert wird.

8. Verfahren nach einem der vorhergehenden Ansprüche, **dadurch gekennzeichnet, dass** bei einem vorgebbaren Ereignis, insbesondere einer Arcerkennung im Plasmaprozess, die Phasenbeziehung von zumindest zwei Ansteuersignalen (C, D), insbesondere sprungartig, geändert wird.

9. Verfahren nach einem der vorhergehenden Ansprüche, **dadurch gekennzeichnet, dass** bei einem vorgebbaren Ereignis, insbesondere einer Arcerkennung im Plasmaprozess, zumindest ein Ansteuersignal (C, D) vorübergehend unterbrochen wird.

10. Verfahren nach einem der vorhergehenden Ansprüche, **dadurch gekennzeichnet, dass** die Frequenzen der Ansteuersignale (C, D) als ganzzahlige Vielfache von 1- 6 MHZ, insbesondere ganzzahlige Vielfache von 3,39 MHz, gewählt werden.

11. Verfahren nach einem der vorhergehenden Ansprüche, **dadurch gekennzeichnet, dass** die digitalen Frequenzgeneratoren (13, 14) durch eine gemeinsame Taktfrequenz angesteuert werden.

12. HF-Generatoransteuereinrichtung (2) zur Ansteuerung von zumindest zwei einen Plasmaprozess mit HF-Leistung speisenden HF-Generatoren (3, 4), wobei die Ansteuereinrichtung (2) zumindest zwei Ansteuersignale (C, D) unterschiedlicher Frequenz generiert, **dadurch gekennzeichnet, dass** die Ansteuereinrichtung (2) für jedes Ansteuersignal (C, D) eine einen insbesondere digitalen Funktionsgenerator (13, 14), insbesondere Sinusgenerator, aufweisende Signalerzeugungsanordnung (10, 11) umfasst.

13. HF-Generatoransteuereinrichtung nach Anspruch 12, **dadurch gekennzeichnet, dass** der Funktionsgenerator (13, 14) als DDS, Direct Digital Synthesizer, ausgebildet ist.

14. HF-Generatoransteuereinrichtung nach Anspruch 12 oder 13, **dadurch gekennzeichnet, dass** die Signalerzeugungsanordnungen (10, 11) eine dem digitalen Funktionsgenerator (13, 14) nachgeschaltete Filtereinrichtung (15, 16) aufweisen.

15. HF-Generatoransteuereinrichtung nach einem der vorhergehenden Ansprüche 12 bis 14, **dadurch gekennzeichnet, dass** die Signalerzeugungsanordnungen (10, 11) einen das jeweilige Ansteuersignal (C, D) erzeugenden Komparator (17, 18) aufweisen.

16. HF-Generatoransteuereinrichtung nach einem der vorhergehenden Ansprüche 12 bis 15, **dadurch gekennzeichnet, dass** ein Prozessor (12) zur Ansteuerung der Signalerzeugungsanordnungen (10, 11) vorgesehen ist.

17. HF-Generatoransteuereinrichtung nach einem der vorhergehenden Ansprüche 12 bis 16, **dadurch gekennzeichnet, dass** ein Oszillator (19) zur Erzeugung eines Taktsignals vorgesehen ist, der mit den Signalerzeugungsanordnungen (10, 11) und/oder dem Prozessor (12) verbunden ist.

18. HF-Generatoransteuereinrichtung nach einem der vorhergehenden Ansprüche 12 bis 17, **dadurch gekennzeichnet, dass** zumindest eine Schnittstelle (20), insbesondere eine serielle Schnittstelle und/oder Benutzerschnittstelle, vorgesehen ist.

19. HF-Generatoransteuereinrichtung nach einem der vorhergehenden Ansprüche 12 bis 18, **dadurch gekennzeichnet, dass** ein programmierbarer Logikbaustein vorgesehen ist.

20. HF-Plasmaanregungsanordnung (1), umfassend wenigstens zwei HF-Generatoren (3, 4), die durch eine HF-Generatoransteuereinrichtung (2) nach einem der Ansprüche 12 bis 19 angesteuert ist.

## Claims

1. Method for generating drive signals (C, D) of at least two RF power generators (3, 4) which supply RF power to a plasma process, wherein at least two drive signals (C, D), each driving one RF power generator (3, 4), are generated in an RF generator drive means (2), **characterized in that** each drive signal (C, D) is generated using a function generator (13, 14) respectively, in particular, a digital function generator, preferentially a digital sine generator, wherein at least two drive signals (C, D) have different frequencies.

2. Method according to claim 1, **characterized in that** a phase and/or frequency relation of the drive signals (C, D) relative to each other is adjusted.

3. Method according to any one of the preceding claims, **characterized in that** the drive signals (C, D) are adjusted via at least one digital interface of the RF generator drive means (2).

4. Method according to any one of the preceding claims, **characterized in that** the drive signals (C, D) are adjusted via a programmable logic component, in particular an FPGA or a processor.

5. Method according to any one of the preceding claims, **characterized in that** the phase position of a drive signal (C, D) is changed over a time period of 1µs to 10s, preferably 1ms to 2s, preferentially 100ms to is.

6. Method according to any one of the preceding claims, **characterized in that** the speed of the phase position change is adjusted, in particular in %/s.

7. Method according to any one of the preceding claims, **characterized in that** at least one drive signal (C, D) is frequency- or phase-modulated.

8. Method according to any one of the preceding claims, **characterized in that** the phase relation of at least two drive signals (C, D) is changed, in particular abruptly, in case of a predeterminable event, in particular, the detection of an arc in the plasma process.

9. Method according to any one of the preceding claims, **characterized in that** at least one drive signal (C, D) is temporarily interrupted in case of a predeterminable event, in particular, the detection of an arc in the plasma process.

10. Method according to any one of the preceding claims, **characterized in that** the frequencies of the drive signals (C, D) are selected as integer multiples of 1 to 6 MHz, in particular, integer multiples of 3.39 MHz.

11. Method according to any one of the preceding claims, **characterized in that** the digital frequency generators (13, 14) are driven by a common clock frequency.

12. RF generator drive means (2) for driving at least two RF generators (3, 4) which feed RF power into a plasma process, wherein the drive means (2) generates at least two drive signals (C, D) of different frequencies, **characterized in that** the drive means (2) comprises one signal generating configuration (10, 11) for each drive signal (C, D), which comprises a function generator (13, 14), in particular a digital function generator, in particular a sine generator.

13. RF generator drive means according to claim 12, **characterized in that** the function generator (13, 14) is designed as DDS, direct digital synthesizer.

14. RF generator drive means according to claim 12 or 13, **characterized in that** the signal generating configurations (10, 11) comprise a filter means (15, 16) which is disposed downstream of the digital function generator (13, 14).

15. RF generator drive means according to any one of the preceding clams 12 through 14, **characterized in that** the signal generating configurations (10, 11) comprise a comparator (17, 18) that generates the respective drive signal (C, D).

16. RF generator drive means according to any one of the preceding claims 12 through 15, **characterized in that** a processor (12) is provided for driving the signal generating configurations (10, 11).

17. RF generator drive means according to any one of the preceding claims 12 through 16, **characterized in that** an oscillator (19) is provided for generating a clock signal, which is connected to the signal generating configurations (10, 11) and/or the processor (12).

18. RF generator drive means according to any one of the preceding claims 12 through 17, **characterized in that** at least one interface (20) is provided, in particular, a serial interface and/or a user interface.

19. RF generator drive means according to any one of the preceding claims 12 through 18, **characterized in that** a programmable logic component is provided.

20. RF plasma excitation configuration (1), comprising at least two RF generators (3, 4) which are driven by an RF generator drive means (2) in accordance with one of the claims 12 through 19.

## Revendications

1. Procédé de génération de signaux de commande (C, D) d'au moins deux générateurs de puissance HF (3, 4) qui alimentent un procédé plasma en puissance HF, dans lequel au moins deux signaux de commande (C, D) commandant chacun un générateur de puissance HF (3, 4) sont générés dans un dispositif de commande de générateur HF (2), **caractérisé en ce que** les signaux de commande (C, D) sont générés en utilisant pour chacun un générateur de fonction (13, 14), en particulier un générateur de fonction numérique, de préférence un générateur sinusoïdal numérique, au moins deux signaux de commande (C, D) présentant des fréquences différentes.

2. Procédé selon la revendication 1, **caractérisé en ce qu'**une relation de phase et/ou de fréquence des signaux de commande (C, D) entre eux est réglée.

3. Procédé selon une des revendications précédentes, **caractérisé en ce que** le réglage des signaux de commande (C, D) est réalisé via au moins une interface numérique du dispositif de commande de générateur HF (2).

4. Procédé selon une des revendications précédentes, **caractérisé en ce que** le réglage des signaux de commande (C, D) est réalisé au moyen d'un composant logique programmable, en particulier un FPGA ou un processeur.

5. Procédé selon une des revendications précédentes, **caractérisé en ce qu'**une modification de la position de phase d'un signal de commande (C, D) a lieu sur un intervalle de temps compris entre 1 µs et 10 s, de préférence entre 1 ms et 2 s, particulièrement préférentiellement entre 100 ms et 1 s.

6. Procédé selon une des revendications précédentes, **caractérisé en ce que** la vitesse de la modification de position de phase est réglée en particulier en %/s.

7. Procédé selon une des revendications précédentes, **caractérisé en ce qu'**au moins un signal de commande (C, D) est modulé en fréquence ou en phase.

8. Procédé selon une des revendications précédentes, **caractérisé en ce que** la relation de phase d'au moins deux signaux de commande (C, D) est modifiée, en particulier soudainement, lors d'un événement prédéfinissable, en particulier une détection d'arc dans le procédé plasma.

9. Procédé selon une des revendications précédentes, **caractérisé en ce qu'**au moins un signal de commande (C, D) est provisoirement interrompu lors d'un événement prédéfinissable, en particulier une détection d'arc dans le procédé plasma.

10. Procédé selon une des revendications précédentes, **caractérisé en ce que** les fréquences des signaux de commande (C, D) sont choisies comme des multiples entiers de 1 à 6 MHz, en particulier des multiples entiers de 3,39 MHz.

11. Procédé selon une des revendications précédentes, **caractérisé en ce que** les générateurs de fréquence numériques (13, 14) sont commandés par une fréquence d'horloge commune.

12. Dispositif de commande de générateur HF (2) pour la commande d'au moins deux générateurs HF (3, 4) alimentant un procédé plasma en puissance HF, le dispositif de commande (2) générant au moins deux signaux de commande (C, D) de fréquence différente, **caractérisé en ce que** le dispositif de commande (2) comprend pour chaque signal de commande (C, D) un dispositif de génération de signaux (10, 11) présentant un générateur de fonction (13, 14) en particulier numérique, en particulier un générateur sinusoïdal.

13. Dispositif de commande de générateur HF selon la revendication 12, **caractérisé en ce que** le générateur de fonction (13, 14) est réalisé sous la forme d'un DDS, Direct Digital Synthesizer.

14. Dispositif de commande de générateur HF selon la revendication 12 ou 13, **caractérisé en ce que** les dispositifs de génération de signaux (10, 11) présentent un dispositif de filtrage (15, 16) placé en aval du générateur de fonction numérique (13, 14).

15. Dispositif de commande de générateur HF selon une des revendications précédentes 12 à 14, **caractérisé en ce que** les dispositifs de génération de signaux (10, 11) présentent un comparateur (17, 18) qui génère le signal de commande (C, D) respectif.

16. Dispositif de commande de générateur HF selon une des revendications précédentes 12 à 15, **caractérisé en ce qu'**un processeur (12) est prévu pour commander les dispositifs de génération de signaux (10, 11).

17. Dispositif de commande de générateur HF selon une des revendications précédentes 12 à 16, **caractérisé en ce qu'**un oscillateur (19) est prévu pour générer un signal d'horloge, lequel est relié aux dispositifs de génération de signaux (10, 11) et/ou au processeur (12).

18. Dispositif de commande de générateur HF selon une des revendications précédentes 12 à 17, **caractérisé en ce qu'**au moins une interface (20) est prévue, en particulier une interface série et/ou une interface utilisateur.

19. Dispositif de commande de générateur HF selon une des revendications précédentes 12 à 18, **caractérisé en ce qu'**un composant logique programmable est prévu.

20. Dispositif d'excitation plasma HF (1), comprenant au moins deux générateurs HF-(3, 4) qui sont commandés par un dispositif de commande de générateur HF (2) selon une des revendications 12 à 19.
